Europäisches Patentamt

European Patent Office

Office européen des brevets

(11) Numéro de publication: **0 319 403**
A1

## (12) DEMANDE DE BREVET EUROPEEN

(21) Numéro de dépôt: **88403009.9**

(22) Date de dépôt: **30.11.88**

(51) Int. Cl.4: **H 01 L 27/14**
**H 04 N 3/15**

(30) Priorité: **04.12.87 FR 8716865**

(43) Date de publication de la demande:
**07.06.89 Bulletin 89/23**

(84) Etats contractants désignés: **DE GB NL**

(71) Demandeur: **THOMSON-CSF**
**51, Esplanade du Général de Gaulle**
**F-92800 Puteaux (FR)**

(72) Inventeur: **Berger, Jean-Luc**
**THOMSON-CSF SCPI 19, avenue de Messine**
**F-75008 Paris (FR)**

**Arques, Marc**
**THOMSON-CSF SCPI 19, avenue de Messine**
**F-75008 Paris (FR)**

(74) Mandataire: **Guérin, Michel et al**
**THOMSON-CSF SCPI**
**F-92045 PARIS LA DEFENSE CEDEX 67 (FR)**

(54) Matrice d'éléments photosensibles associant une photodiode ou un phototransistor et une capacité de stockage.

(57) L'invention concerne les matrices d'éléments photosensibles.

Dans une matrice photosensibles dont la structure utilise à chaque point photosensible un élément photosensible (photodiode PIN) en série avec une capacité entre un conducteur de ligne (12) et un conducteur de colonne (22), on propose ici d'utiliser un élément photosensible simplifié dont une couche semiconductrice extrême est supprimée; par exemple, on supprime la couche N d'une photodiode PIN, ou la couche N d'un phototransistor à cinq couches de type NIPIN. Le diélectrique (20) de la capacité vient alors directement en contact avec une couche semiconductrice intrinsèque (16) dans laquelle s'accumulent des électrons qui reconstituent l'équivalent d'une couche dopée de type N.

On simplifie ainsi la fabrication, et on diminue les pertes de photons dans la couche semiconductrice qui devait auparavant être traversée par le rayonnement lumineux.

FIG.3

## Description

## MATRICE D'ELEMENTS PHOTOSENSIBLES ASSOCIANT UNE PHOTODIODE OU UN PHOTOTRANSISTOR ET UNE CAPACITE DE STOCKAGE

L'invention concerne les barrettes ou matrices d'éléments photosensibles.

Pour réaliser des matrices d'éléments photosensibles, il est classique de prévoir un réseau de conducteurs en ligne, et un réseau de conducteurs en colonne, avec, à chaque croisement d'une ligne et d'une colonne, un élément photosensible respectif. Par le réseau de lignes on sélectionne une ligne d'éléments photosensibles dont on veut connaître les signaux électriques de sortie; par le réseau de conducteurs de colonnes, on lit un signal de sortie respectif pour chacun des éléments de la ligne sélectionnée.

Une méthode pour permettre la sélection individuelle d'une ligne et la lecture individuelle sur chaque colonne consiste à utiliser en chaque point de la matrice l'association d'un élément photosensible proprement dit et d'un transistor d'accès. L'élément photosensible est une photodiode ou un phototransistor (ce dernier ayant l'avantage d'une plus grande sensibilité, c'est-à-dire qu'il fournit une charge électrique supérieure pour un même éclairement). Cette photodiode est reliée par l'intermédiaire du transistor d'accès à un conducteur de colonne de la matrice. Ce transistor est commandé par un conducteur de ligne (et tous les éléments photosensibles de la même ligne sont ainsi connectés au même conducteur de ligne).

L'inconvénient de ce type de structure est qu'il nécessite en chaque point de la matrice à la fois une photodiode et un transistor d'accès disposé à côté de la photodiode; cette structure est encombrante à cause de la surface consommée par le transistor d'accès en chaque point de la matrice.

Pour réduire l'encombrement, c'est-à-dire en fait pour augmenter la résolution en logeant un plus grand nombre de points dans une surface donnée, on a proposé des structures dans lesquelles le transistor d'accès est supprimé et remplacé par une capacité servant d'une part à stocker les charges engendrées par la photodiode et d'autre part à isoler la photodiode du conducteur de colonne lorsque la ligne correspondant à cette photodiode n'est pas sélectionnée.

Une telle structure est décrite par exemple dans le brevet français 86 00716. L'avantage de la capacité par rapport au transistor est qu'elle peut être disposée au dessus et non à côté de la photodiode, ce qui réduit l'encombrement.

En particulier, une méthode pratique de réalisation d'une telle matrice d'éléments photosensibles consiste à superposer trois couches de silicium amorphe dopées de type P, I, et N et une couche diélectrique, le tout placé en sandwich entre un conducteur de ligne et un conducteur de colonne de la matrice.

L'éclairement de la photodiode se fait d'un côté ou de l'autre et engendre des charges électriques principalement dans la zone intrinsèque de la diode. Ces charges viennent s'accumuler à l'interface entre la photodiode et la capacité, c'est-à-dire dans la couche de type N de la photodiode si la capacité est située du côté de la couche N, ou dans la couche P dans le cas contraire.

Selon l'invention, on a remarqué que l'on pouvait dans certains cas supprimer complètement cette couche dopée sans altérer sensiblement le fonctionnement de la matrice, sauf peut-être en ce qui concerne la rapidité de transert des charges stockées vers le conducteur de colonne par l'intermédiaire duquel se fait la lecture du signal généré par la photodiode.

Cette possibilité de suppression de la couche dopée adjacente à la capacité de stockage de charges repose sur l'idée qu'une zone d'accumulation de charges (du même type que celle de la couche dopée) se constitue à l'interface entre la photodiode et la capacité au fur et à mesure de l'illumination.

Par conséquent, il n'est pratiquement pas nécessaire de prévoir un véritable dopage chimique de cette interface pour constituer une zone remplie de porteurs libres.

Selon l'invention, on prévoit donc un réseau d'éléments photosensibles dans lequel chaque point photosensible comporte, entre un conducteur de ligne et un conducteur de colonne, un élément photosensible en série avec une capacité, l'élément photosensible comportant au moinsune couche semiconductrice non dopée (intrinsèque ou quasi-intrinsèque), caractérisé en ce que la capacité est constituée par :
- cette couche non dopée dans laquelle viennent s'accumuler des charges au fur et à mesure de l'illumination;
- une couche diélectrique en contact avec cette couche non dopée;
- et un conducteur de ligne ou de colonne en contact avec la couche diélectrique.

Dans le cas où l'élément photosensible est une photodiode PIN, la structure en chaque point de la matrice devient une superposition d'un conducteur (de ligne ou de colonne), d'une couche semiconductrice dopée en contact avec ce conducteur, d'une couche semiconductrice non dopée (intrinsèque ou quasi-intrinsèque), d'une couche isolante, et d'un autre conducteur (de colonne ou de ligne).

Par cette disposition, non seulement on supprime une opération de dopage ou de dépôt d'une couche dopée, mais en plus on améliore le rendement photoélectrique puisque une plus grande partie du rayonnement incident est reçue par la couche intrinsèque; les pertes de transmission dans la couche N+ ou P+ de la photodiode sont supprimées, et le rendement pour les longueurs d'onde lumineuses courtes (bleues ou violettes) est nettement amélioré, car l'absorbtion de la couche N+ ou P+ était particulièrement forte pour ces longueurs d'onde.

Dans une variante de réalisation de l'invention, l'élément photosensible dans lequel on supprime une couche dopée en contact avec le diélectrique de la capacité est non pas une photodiode PIN mais un phototransistor à cinq couches semiconductrices de type NIPIN ou PINIP. Cette réalisation sera décrite en détail plus loin, mais d'ores et déjà on peut noter le caractère inattendu de cette réalisation en ce sens que les matrices photosensibles utilisant comme point photosensible un élément photosensible en série avec une capacité, sans transistor d'accès pour adresser une ligne de points choisie, excluent a priori l'emploi de phototransistors comme élément photosensible.

En effet, si on a pu proposer dans le passé des points photosensibles utilisant une photodiode en série avec une capacité, c'est parce que les charges générées par l'éclairement viennent se stocker à l'interface entre la diode et la capacité et que la lecture peut se faire par mise en conduction de la photodiode pour évacuer vers le conducteur de colonne les charges stockées (ou pour amener du conducteur de colonne une quantité de charges compensant les charges stockées). Ceci est très facile avec une photodiode qui peut être rendue conductrice tout simplement par une impulsion de polarisation en direct (polarisation positive du côté de l'anode, négative du côté de la cathode). Mais c'est pratiquement impossible avec un phototransistor à base flottante qui ne peut être rendu conducteur dans un sens propre à l'évacuation des charges stockées que par mise en avalanche de sa jonction base-émetteur; non seulement cette mise en avalanche requiert une tension de polarisation assez élevée, mais en plus le courant de conduction qui en résulte introduit un bruit important (transfert de charges parasites qui ne correspondent pas aux charges générées par l'illumination). Ce problème est encore plus délicat à résoudre si la phase de lecture a lieu dans l'obscurité

L'invention propose ici d'utiliser une matrice dont le point photosensible comprend une superposition de couches NIPI ou PINI, c'est-à-dire un transistor NIPIN ou PINIP dont une couche dopée extrême a été supprimée, avec une couche isolante recouvrant la couche intrinsèque extrême de la superposition NIPI ou PINI, l'ensemble étant placé en sandwich entre deux conducteurs qui sont respectivement un conducteur de ligne et un conducteur de colonne de la matrice.

Cette disposition avec une sorte de phototransistor à quatre couches est plus favorable que la disposition avec une simple photodiode car d'une part le rendement photoélectrique de ce phototransistor est plus élevé que celui d'une photodiode PIN, et d'autre part on a remarqué que la mise en conduction pour l'évacuation des charges en phase de lecture pouvait se faire sous une tension pratiquement aussi faible que la mise en conduction d'une photodiode, et ceci même dans l'obscurité (car la lecture se fera souvent dans l'obscurité) et sans introduire un bruit de charges important. Pour optimiser ces problèmes de mise en conduction de la structure au moment de la lecture des charges générées par effet photoélectrique, on prévoit que la couche intrinsèque située entre deux couches de types de conductivité opposées est très mince (de préférence de l'ordre de 200 angströms ou moins); par ailleurs la couche intrinsèque extrême, en contact avec la couche isolante, est beaucoup plus épaisse, de préférence plusieurs milliers d'angströms, pour assurer une sensibilité suffisante.

La matrice photosensible selon l'invention sera réalisée de préférence par une superposition de couches de silicium amorphe hydrogéné. Ces couches sont en principe gravées pour définir des îlots photosensibles séparés constituant les points photosensibles de la matrice, mais on peut prévoir aussi que certaines couches ne soient pas gravées si la conductivité latérale entre points photosensibles est suffisamment faible compte-tenu du faible dopage de certaines couches ou de leur faible épaisseur.

D'autres caractéristiques et avantages de l'invention apparaîtront à la lecture de la description détaillée qui suit et qui est faite en référence aux dessins annexés dans lesquels:

- La figure 1 représente symboliquement le schéma électrique d'un point photosensible d'une matrice de type connu;

- la figure 2 représente, en coupe latérale, un exemple de réalisation pratique de matrice de l'art antérieur avec une photodiode PIN en série avec une capacité à chaque point de la matrice;

- la figure 3 représente, en coupe latérale, un exemple de réalisation d'une matrice selon l'invention;

- la figure 4 représente une variante de réalisation de la figure 3;

- la figure 5 représente un autre exemple de réalisation d'une matrice selon l'invention, utilisant comme élément photosensible une sorte de phototransistor;

- la figure 6 représente une variante de réalisation avec phototransistor;

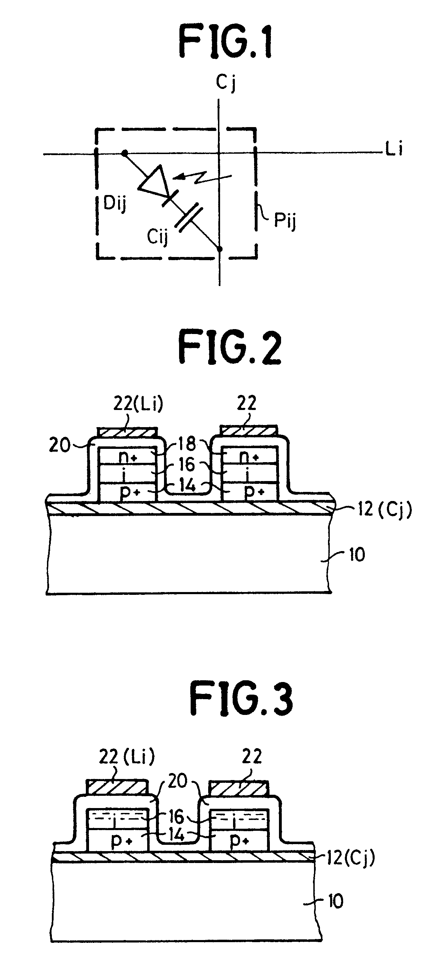

A la figure 1, on a représenté d'une manière symbolique un point d'une matrice de points photosensibles de la technique antérieure; cette matrice comporte un certain nombre de lignes et de colonnes et chaque point photosensible $P_{ij}$ est localisé au carrefour d'une ligne $L_i$ de rang i et d'une colonne $C_j$ de rang j.

La ligne $L_i$ est matérialisée par un conducteur électrique orienté "horizontalement", et la colonne $C_j$ est matérialisée par un conducteur $C_j$ orienté "verticalement".

Le point photosensible comporte une photodiode $D_{ij}$ en série avec une capacité $C_{ij}$; cet ensemble en série est connecté entre le conducteur de ligne $L_i$ et le conducteur de colonne $C_j$.

Lorsque la photodiode est illuminée, des charges électriques sont engendrées et stockées au point de jonction entre la diode et la capacité. On s'arrange pour que, pendant l'illumination, la diode soit polarisée en inverse aussi bien pour un faible éclairement que pour un fort éclairement (dans les limites de fonctionnement normal autorisées pour la matrice).

En dehors de la phase d'illumination, on lit les charges stockées en polarisant la diode en direct durant un bref instant; cette polarisation directe est faite en portant le conducteur de ligne à un potentiel approprié et elle permet d'évacuer les charges stockées; le courant d'évacuation qui en résulte sur la colonne Cj est mesuré par un amplificateur intégrateur.

La photodiode Dij est une diode PIN, qui présente de bonnes caractéristiques photoélectriques.

La figure 2 représente une réalisation pratique connue correspondant à la figure 1. Cette réalisation peut être très compacte car on réalise la photodiode (Dij) et la capacité (Cij) par simple empilement de couches semiconductrices (pour la diode) et isolantes (pour la capacité) entre les conducteurs de ligne et les conducteurs de colonne.

Sur un substrat isolant 10, de préférence en verre transparent aux longueurs d'onde auxquelles sont sensibles les photodiodes, on dépose un premier réseau de conducteurs parallèles 12 constituant par exemple les conducteurs de colonne Cj de la figure 1 (mais ce pourrait être aussi les conducteurs de ligne Li). Le matériau constituant ces conducteurs 12 est de préférence un matériau transparent (oxyde d'indium-étain ITO), notamment dans le cas où on désire remettre à un niveau fixe le potentiel de la capacité Cij par un flash lumineux à l'arrière du substrat après chaque lecture.

Sur le substrat ainsi recouvert d'un réseau de conducteurs de lignes ou colonnes, on dépose les couches semiconductrices servant à former les photodiodes et la couche isolante servant de diélectrique à la capacité, de manière à superposer, en chaque point de la matrice, une photodiode et une capacité.

Dans le cas de la figure 2, on forme d'abord les photodiodes puis la capacité. On dépose donc successivement une couche semiconductrice 14 dopée d'un premier type de conductivité (par exemple P), puis une couche semiconductrice intrinsèque 16, puis une couche semiconductrice 18 dopée avec une impureté du type de conductivité opposé; on grave ces couches semiconductrices pour définir des photodiodes isolées les unes des autres; puis on dépose une couche isolante 20, par exemple en oxyde ou en nitrure de silicium; enfin on dépose une couche conductrice 22, transparente ou semi-transparente dans le cas où l'illumination se fait par le haut; par exemple la couche 22 est également en oxyde d'indium-étain; on la grave pour définir un réseau de conducteurs perpendiculaires aux conducteurs 12 et recouvrant les photodiodes. Si les conducteurs 12 sont des conducteurs de ligne, alors les conducteurs 22 sont des conducteurs de colonne et réciproquement.

Les couches semiconductrices sont en silicium amorphe, hydrogéné.

Par couche intrinsèque, on entend dans toute cette description une couche qui n'est pas ou pratiquement pas dopée avec des impuretés susceptibles d'augmenter sa teneur en porteur de charges libres positives (impuretés de type P) ou négatives (impuretés de type N); mais cela n'exclut pas un dopage différent tel qu'un dopage à l'hydrogène pour saturer les liaisons brisées du silicium amorphe ou un dopage au carbone pour augmenter la transparence du semiconducteur à certaines longueurs d'onde.

Pour plus de détails sur cette technique antérieure, on pourra se référer au brevet français 86 00716.

Selon l'invention, on réalise une structure telle que celle de la figure 3 qui est très proche de la figure 2. La seule différence est l'absence de la couche 18 au dessous de la couche isolante 20. Les autres couches sont identiques à celles de la figure 2 et portent les mêmes références sur ces deux figures.

Lorsque la structure est illuminée, les différences de potentiel appliquées entre ligne et colonne sont telles que les paires électrons-trous générées par l'illumination se séparent entre charges d'un signe dirigées vers la couche dopée 14 adjacente à un conducteur 12 et charges du signe opposé dirigées vers l'interface entre la couche intrinsèque 16 et la couche isolante 20.

Dans le cas de la figure 3, la couche dopée est une couche de type P, et des électrons viennent donc s'accumuler à l'interface entre couche intrinsèque 16 et couche isolante 20, constituant l'équivalent d'une couche dopée superficielle de type N.

Après la phase d'illumination, on passe à une phase de lecture, qui a lieu en général dans l'obscurité ; on applique entre ligne et colonne une impulsion de tension créant un champ électrique qui attire les charges stockées vers la région dopée 14 et qui les évacue vers le conducteur 12. Le courant d'évacuation est mesuré et intégré par un amplificateur intégrateur relié au conducteur de colonne.

Après la phase de lecture, on prévoit en général une phase de remise à niveau des potentiels en vue de la phase d'illumination suivante. Par exemple on éclaire les photodiodes par l'arrière avec un flash lumineux intense suivi d'une polarisation directe de la photodiode par une impulsion de tension plus faible que dans la phase de lecture.

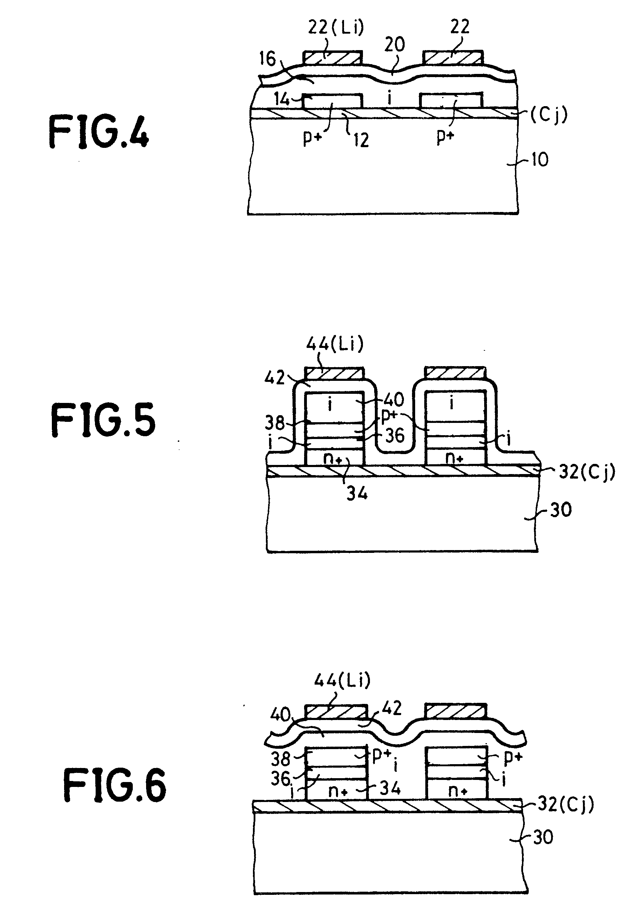

Dans une variante de réalisation représentée à la figure 4, on peut prévoir que la couche semiconductrice intrinsèque 16 n'est pas gravée: après dépôt de la couche 14 de type P, on grave cette couche en îlots correspondant à chaque photodiode à réaliser, ou en bandes correspondant à une ligne ou une colonne de photodiodes, ces bandes recouvrant les bandes conductrices 12. Ensuite on dépose la couche semiconductrice intrinsèque 16, mais on ne la grave pas, en tenant compte du fait que sa résistivité est grande et que le couplage latéral entre photodiodes adjacentes est très faible.

Dans certains cas, on pourrait même envisager de ne pas graver la couche dopée 14 en contact avec le conducteur 12 si sa conductivité latérale est suffisamment faible pour que les impulsions de mise en conduction appliquées aux photodiodes d'une ligne ne se transmettent pas aux lignes adjacentes.

L'avantage de ces structures non gravées ou partiellement gravées est d'améliorer la planarisation de la structure avant dépôt des conducteurs 22.

Dans certains cas, on pourra préférer que la capacité soit déposée avant la photodiode, auquel cas la succession des couches déposées sur le substrat est la suivante: couche conductrice 12, couche isolante 20, couche semiconductrice intrinsèque 16, couche semiconductrice dopée 14, couche conductrice 22.

A la figure 5, on a représenté un autre mode de réalisation dans lequel l'élément photosensible est constitué par la superposition de quatre couches semiconductrices et une couche isolante, en sandwich entre un conducteur de ligne et un conducteur de colonne.

Le substrat utilisé, 30, est de même type que celui décrit en référence aux dessins précédents; on dépose sur ce substrat des conducteurs 32 de ligne ou colonne de la même façon qu'à la figure 3.

Puis on dépose quatre couches semiconductrices successives qui sont respectivement:
- une couche 34 dopée d'un premier type de conductivité, N dans l'exemple représenté;
- une couche intrinsèque ou quasi-intrinsèque 36;
- une couche 38 dopée d'un deuxième type de conductivité opposé au premier;
- une autre couche intrinsèque ou quasi-intrinsèque 40.

Ces quatre couches semiconductrices sont gravées pour définir des îlots séparés constituant les éléments photosensibles de la matrice. Les couches sont en silicium amorphe hydrogéné comme pour la photodiode des figures précédentes.

L'épaisseur de la couche intrinsèque 36, c'est-à-dire celle qui est située entre deux couches dopées de types de conductivité opposés, est très faible; elle est par exemple de 200 angströms ou moins; au contraire, la couche intrinsèque 40, qui sera en contact avec l'isolant de la capacité, est beaucoup plus épaisse, de préférence au moins dix fois plus épaisse; à titre d'exemple, l'épaisseur peut être comprise entre 2000 et 5000 angströms.

Après gravure des couches semiconductrices, on dépose une couche isolante 42, par exemple en oxyde ou nitrure de silicium, qui constitue le diélectrique de la capacité en série avec l'élément photosensible.

Puis, on dépose une couche conductrice 44, de préférence transparente ou semi-transparente, par exemple en oxyde d'indium-étain, que l'on grave pour définir un réseau de conducteurs de colonne ou ligne perpendiculaire au réseau de conducteurs 32 et passant au dessus des îlots de silicium amorphe.

La capacité est définie par un conducteur 44 d'un côté du diélectrique 42 et par la couche semiconductrice intrinsèque 40 de l'autre côté du diélectrique, des charges électriques générées par l'éclairement venant s'accumuler à l'interface 40, 42 sous l'effet du champ électrique présent dans la couche intrinsèque 40 pendant l'éclairement.

Le fonctionnement du point photosensible est le suivant : on travaille en trois phases qui sont respectivement une phase d'illumination, une phase de lecture, et une phase de remise à niveau des potentiels.

Pendant la phase d'illumination, la tension appliquée entre ligne et colonne est telle que la jonction base-émetteur (entre couche 38 et couche 34) soit légèrement polarisée en inverse et que le champ électrique dans la zone intrinsèque épaisse 40 attire vers la capacité les porteurs minoritaires de la base du phototransistor, c'est-à-dire de la couche 38.

Pour une structure NIPI le potentiel sera positif du côté I et négatif du côté N et les électrons seront entraînés vers la capacité.

Plus précisément, l'illumination engendre dans la zone intrinsèque épaisse des porteurs de charge qui s'accumulent sur la base et débloquent la jonction émetteur-base qui n'est que très légèrement polarisée en inverse. Il en résulte un courant important de porteurs minoritaires (d'autant plus important que le gain du phototransistor est plus important) ; ces porteurs s'accumulent sur la capacité et ils sont en nombre plus important que les porteurs générés initialement par l'illumination dans la zone intrinsèque 40.

Les porteurs accumulés à l'interface entre la zone intrinsèque 40 et l'isolant de la capacité recréent artificiellement la zone dopée N qu'on a volontairement supprimée.

Dans la phase de lecture, en général dans l'obscurité, on applique une impulsion de tension sur le conducteur de ligne dans un sens qui inverse le champ électrique dans la zone intrinsèque épaisse 40. Les charges stockées sont évacuées vers la zone dopée 34 et vers le conducteur 32 avec lequel cette zone est en contact.

L'impulsion de tension de lecture a une amplitude faible, même si l'on est dans l'obscurité, et elle est du même ordre que celle utilisée pour une photodiode, ceci grâce à la présence et à la faible épaisseur de la zone intrinsèque la plus mince 36. Le courant d'évacuation des charges stockées peut être lu et intégré à partir du conducteur de colonne, que celui-ci soit le conducteur 32 ou le conducteur 34.

Dans une phase de remise à niveau des potentiels initiaux, en prévision d'une nouvelle phase de lecture, on peut éclairer le phototransistor par l'arrière du substrat, et effectuer une lecture avec des impulsions de tension calibrées plus faibles que celles utilisées pendant la phase de lecture proprement dite.

Dans une variante de réalisation visible à la figure 6, on dépose d'abord les trois premières couches semiconductrices 34, 36, 38, puis on les grave pour définir des îlots correspondant à chaque élément photosensible, puis on dépose la dernière couche intrinsèque 40, celle qui sera en contact direct avec l'isolant de la capacité, et on ne grave pas cette couche. Du fait de son épaisseur, elle planarise notablement la structure, ce qui facilite le dépôt ultérieur de la couche métallique 44. L'inconvénient de cette structure est le risque de fuites de charges entre éléments photosensibles adjacents, mais ce risque est faible compte-tenu de la forte résistivité de la couche intrinsèque 40.

L'invention est applicable à toutes sortes de dispositifs photosensibles, y compris à des dispositifs de prise d'image radiologiques dans lesquels un scintillateur, déposé sur les matrices décrites précédemment, convertit un rayonnement X en un rayonnement dans la gamme de longeurs d'ondes auxquelles sont sensibles les structures PI, NIPI ou PINI décrites. Le scintillateur peut d'ailleurs être déposé sur le substrat 10 ou 30 avant réalisation des points photosensibles.

## Revendications

1. Réseau d'éléments photosensibles dans lequel chaque point photosensible comporte, entre un conducteur de ligne (Li) et un conducteur de colonne (Cj), un élément photosensible (Dij) en série avec une capacité (Cij), l'élément photosensible comportant au moins une couche semiconductrice (14,40) intrinsèque ou quasi intrinsèque, caractérisé en ce que la capacité est constituée par :
- cette couche (16,40) intrinsèque ou quasi intrinsèque dans laquelle viennent s'accumuler des charges au fur et à mesure de l'illumination :
- une couche diélectrique (20,42) en contact avec cette couche intrinsèque ou quasi intrinsèque ;
- et un conducteur de ligne ou de colonne (44) en contact avec la couche diélectrique.

2. Réseau d'éléments photosensibles selon la revendication 1, caractérisé en ce que l'élément photosensible est constitué par la couche intrinsèque ou quasi intrinsèque, en contact, de l'autre côté de la couche diélectrique, avec une couche semiconductrice dopée (14).

3. Réseau d'éléments photosensibles selon la revendication 2, caractérisé en ce que chaque point photosensible comporte la superposition, sur un substrat (10), d'une portion de conducteur de ligne ou colonne, d'une couche semiconductrice dopée (14), d'une couche semiconductrice intrinsèque ou quasi intrinsèque (16), d'une couche diélectrique (20), et d'une portion de conducteur de colonne ou ligne.

4. Réseau d'éléments photosensibles selon la revendication 2, caractérisé en ce que chaque point photosensible comporte la superposition, sur un substrat (10), d'une portion de conducteur de ligne ou colonne, d'une couche diélectrique, d'une couche semiconductrice intrinsèque, d'une couche semiconductrice dopée, et d'une portion de conducteur de colonne ou ligne.

5. Réseau d'éléments photosensibles selon l'une des revendications 2 à 4, caractérisé en ce que les éléments photosensibles sont délimités par gravure de la couche semiconductrice dopée (14), la couche intrinsèque (16) n'étant pas gravée et s'étendant uniformément entre les éléments photosensibles ainsi délimités.

6. Réseau d'éléments photosensibles selon la revendication 1, caractérisé en ce que l'élément photosensible est constitué par la superposition d'une première couche semiconductrice (34) dopée d'un premier type de conductivité, d'une première couche semiconductrice intrinsèque ou quasi intrinsèque mince (36), d'une couche semiconductrice (38) dopée d'un deuxième type de conductivité opposé au premier, et d'une couche semiconductrice intrinsèque ou quasi-intrinsèque (40) plus épaisse que la première, cette dernière étant en contact avec la couche diélectrique (42).

7. Réseau selon la revendication 6, caractérisé en ce que le point photosensible est consitué par la superposition de couches suivantes sur un substrat (30) :
- une couche conductrice de conducteur de ligne ou colonne (32) déposée sur la surface du substrat ;
- la couche semiconductrice dopée du premier type de conductivité (34) ;
- la première couche intrinsèque mince (36) ;
- la couche semiconductrice dopée du type opposé (38) ;
- la deuxième couche semiconductrice intrinsèque plus épaisse (40) ;
- la couche diélectrique (42) ;
- une couche de conducteur de colonne ou ligne.

8. Réseau selon la revendication 7, caractérisé en ce que les différents points photosensibles sont délimités par gravure de certaines des couches semiconductrices en forme d'îlots séparés correspondant chacun à un élément photosensible respectif, d'autres couches semiconductrices n'étant pas gravées, et notamment la couche intrinsèque plus épaisse (40).

9. Réseau selon l'une des revendications précédentes, caractérisé en ce que les couches semiconductrices sont en silicium amorphe hydrogéné.

# FIG.1

# FIG.2

# FIG.3

FIG.4

FIG.5

FIG.6

Office européen
des brevets

**RAPPORT DE RECHERCHE EUROPEENNE**

Numero de la demande

EP  88 40 3009

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y,D | EP-A-0 233 104  (THOMSON CSF) <br> * Figures 1,5,6; colonne 7, ligne 40 - colonne 8, ligne 31 * | 1 | H 01 L  27/14 <br> H 04 N   3/15 |
| A | --- | 2-9 | |
| Y | US-A-3 916 268  (W.E. ENGELER et al.) <br> * Figure 1; revendications 1,3 * | 1 | |

**DOMAINES TECHNIQUES RECHERCHES (Int. Cl.4)**

H 01 L
H 04 N

Le présent rapport a été établi pour toutes les revendications

| Lieu de la recherche | Date d'achèvement de la recherche | Examinateur |
|---|---|---|
| LA HAYE | 24-02-1989 | CARDON A. |